# EUROPEAN PATENT SPECIFICATION

(11) **EP 1 220 389 B1**
(45) Date of publication and mention of the grant of the patent: **02.04.2003**
(21) Application number: 01121409.5
(22) Date of filing: 07.09.2001
(51) Int. Cl.: H01S 3/106, H01S 5/14

(54) **Optical path length variation using a liquid crystal for tuning a laser**
Änderung der optischen Weglänge mittels eines Flüssigkristalls zur Abstimmung eines Lasers
Modification de la longuer du trajet optique utilisant un cristal liquide pour accorder un laser

(43) Date of publication of application: 03.07.2002
(73) Proprietor: Agilent Technologies, Inc. (a Delaware corporation), Palo Alto, CA 94303 (US)
(72) Inventor: Steffens, Wolf, 71083 Herrenberg (DE); Kallmann, Ulrich, 72070 Tübingen (DE)
(74) Representative: Barth, Daniel

(56) References cited:
- EP-A- 0 329 328
- EP-A- 0 426 102
- EP-A- 0 687 045
- EP-A- 0 852 415
- DE-A- 4 212 779
- US-A- 4 803 692
- US-A- 4 937 833
- US-A- 5 029 174
- US-A- 5 097 476
- US-A- 5 283 796
- US-A- 5 889 798
- PATENT ABSTRACTS OF JAPAN vol. 012, no. 153 (E-607), 11 May 1988 (1988-05-11) -& JP 62 268172 A (YOKOGAWA ELECTRIC CORP), 20 November 1987 (1987-11-20)
- PATENT ABSTRACTS OF JAPAN vol. 1995, no. 04, 31 May 1995 (1995-05-31) -& JP 07 015062 A (NIPPON TELEGR & TELEPH CORP), 17 January 1995 (1995-01-17)
- KOUROGI M ET AL: "LIMIT OF OPTICAL-FREQUENCY COMB GENERATION DUE TO MATERIAL DISPERSION" IEEE JOURNAL OF QUANTUM ELECTRONICS, IEEE INC. NEW YORK, US, vol. 31, no. 12, 1 December 1995 (1995-12-01), pages 2120-2125, XP000541555 ISSN: 0018-9197
- PATENT ABSTRACTS OF JAPAN vol. 016, no. 491 (P-1434), 12 October 1992 (1992-10-12) -& JP 04 177226 A (ASAHI GLASS CO LTD), 24 June 1992 (1992-06-24)
- LASCHEK M ET AL: "Electro-optical frequency modulation of an external-cavity diode laser" OPTICS COMMUNICATIONS, NORTH-HOLLAND PUBLISHING CO. AMSTERDAM, NL, vol. 153, no. 1-3, 15 July 1998 (1998-07-15), pages 59-62, XP004146329 ISSN: 0030-4018
- BINKS D J ET AL: "FREQUENCY LOCKING OF A PULSED SINGLE-LONGITUDINAL-MODE LASER IN A COUPLED-CAVITY RESONATOR" APPLIED OPTICS, OPTICAL SOCIETY OF AMERICA,WASHINGTON, US, vol. 36, no. 36, 20 December 1997 (1997-12-20), pages 9371-9377, XP000737203 ISSN: 0003-6935
- PATENT ABSTRACTS OF JAPAN vol. 013, no. 429 (E-823), 25 September 1989 (1989-09-25) & JP 01 160072 A (KOMATSU LTD), 22 June 1989 (1989-06-22)

## Description

### BACKGROUND OF THE INVENTION

The present invention relates to tuning a laser.

In the optical communication industry there is a need for testing optical components and amplifiers with lasers that can be tuned and influenced as required.

### SUMMARY OF THE INVENTION

Therefore, it is an object of the invention to provide improved influencing of a laser. The object is solved by the independent claims.

According to the present invention, a liquid crystals (LC) being sensitive in a characteristic property is applied in a path of a laser beam. The characteristic property can then be changed or varied for influencing the optical path length of the path.

The liquid crystals (LC) (in the following - for the sake of simplicity - only referred to as 'material') can be any allowing to controllably vary its optical path length by applying a control property or signal thereto. Preferred embodiments may comprise pressure or stress induced variations of the optical path length.

The present invention thus allows influencing the optical path length of the laser beam traveling e.g. in a cavity. The invention provides easy and precise influencing for tuning a laser beam, stabilizing a mode of a laser beam, and - in preferred embodiments - stabilizing the wavelength of the laser beam or filtering a certain wavelength of a laser beam. Influencing a laser according to the present invention makes it possible to enhance the quality of the laser beam produced by the used laser source or laser cavity just by using known laser sources or laser cavities and incorporating the invention.

By using LCs, the present invention can be realized simple and cheap. The LC can be connected to a voltage source and can be influenced therewith easily. Especially the refractive index of such a LC can be influenced by different voltages and/or currents applied to the LC. By placing such LC in the path on which a laser beam is traveling, the optical path length of such a path can be manipulated easily.

A preferred embodiment of the present invention is claimed in a parallel European patent application No. 01121408.7 filed by the applicant.

In a further preferred embodiment, the change of the optical path length is modulated, preferably in a sinusoidal way. This can be done by providing a (e.g. sinusoidally) modulated electrical control signal for the LC that produces a (sinusoidal) optical path length variation. This leads to a frequency modulated output laser light with sidebands located at the carrier modulation frequencies and their higher harmonics if such LC is provided for tuning a laser.

For tuning a laser according to the invention, it is further preferred to change the optical path length to stabilize a mode of the laser beam within a small wavelength range. This range can be of the order of one mode spacing. In this embodiment, it is possible by a change of the optical path length to shift the lasing mode to the desired wavelength. This can also be done applying an external electrical signal to the LC as a control signal for the reflective index of the LC to tune the laser to the desired wavelength.

Another example of the inventive method provides a reduction of coherence of the laser light. This reduction can be used to avoid stimulated Brillouin Scattering or to avoid unwanted interference. A rapid change of the lasing mode wavelength by a change of the optical path length will produce laser light with these properties. An electrical control signal, which can be derived for example from random noise, can allow for the necessary optical path variations caused by the variation of the refractive index of the LC.

A preferred embodiment of the invention uses the LC being a part of an etalon. This can be done for example by using a LC with highly reflective coatings on both sides. In such a LC, the highly reflective coated sides are the etalon mirrors. The tuning effect is again due to the optical path length change between the two highly reflective coated etalon mirrors. This device can be placed in the cavity of a laser source and its transmission wavelength can be controlled by the applied electrical signal to the LC. Furthermore, it is possible to reduce light at unwanted wavelengths (for example Source Spontaneous Emission (SSE) or longitudinal side modes), if the tuning mechanism of the tunable laser source in which the LC is placed and the etalon transmission wavelength are at least approximately synchronized which each other.

Another preferred embodiment of the invention uses the LC in the path of the laser beam for providing a wave front correction of the laser beam. To achieve this goal the LC can be built to provide a spatial variation, preferably a lateral variation of its properties, e.g. the refractive index. This can be achieved for example by multiple electrodes on each side of a LC layer. Individually switched these electrodes can produce a controllable electrical field, which varies over the lateral expansion of the respective LC layer. This variation can be utilized to correct the wave front errors or to create wave fronts with controllable and/or defined characteristics. A preferred embodiment for wave front variations is to emulate a 'lens' by laterally varying (i.e. perpendicular to the propagation direction of the laser beam) the refractive index effect.

The above-mentioned LC devices have the advantage that they can be placed anywhere within a cavity of a laser source. They can be inserted as a transmissive device, placed anywhere in the beam path. Preferably, they are slightly tilted with respect to the incoming beam to avoid any unwanted multi mirror effects due to none perfect antireflection coatings of the respective LC. However, a LC can also be used as a reflective device. For such a reflective device one side of the LC device is highly reflective coated and acts as a cavity mirror. However, it is clear that the body of the LC is still in the path of the laser beam. Therefore, the body of the LC is still a transmissive device. Moreover, the other side of such LC device can still be antireflective coated to allow for maximum transmission into the body of the LC.

Other preferred embodiments are shown by the dependent claims.

It is clear that the invention can be partly embodied or supported by one or more suitable software programs, which can be stored on or otherwise provided by any kind of data carrier, and which might be executed in or by any suitable data processing unit.

### BRIEF DESCRIPTION OF THE DRAWINGS

Other objects and many of the attendant advantages of the present invention will be readily appreciated and become better understood by reference to the following detailed description when considering in connection with the accompanied drawings. The components in the drawings are not necessarily to scale, emphasis instead being placed upon clearly illustrating the principles of the present invention. Features that are substantially or functionally equal or similar will be referred to with the same reference sign(s).

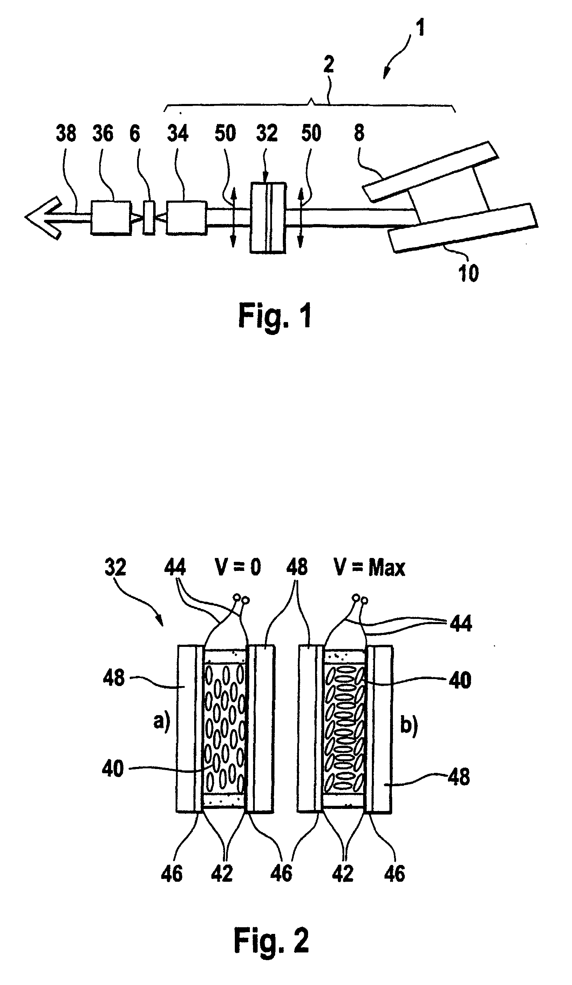

- Fig. 1-4: show different embodiments of the present invention.

### DETAILED DESCRIPTION OF THE INVENTION

Referring now in greater detail to the drawings, Fig. 1 shows a schematic view of a first embodiment 1 of the apparatus of the present invention. The apparatus 1 of Fig. 1 comprises an external cavity 2, in which laser light provided by an active medium (not shown), e.g. a laser diode, can resonate to provide a laser beam 4. The beam 4 travels in the cavity 2 along a path between a cavity end element 6 and a tuning element 8 of the external cavity 2. The cavity end element 6 and the tuning element 8 both (providing a high reflective mirror) providing the cavity mirrors.

The apparatus 1 further comprises a dispersion element 10 introduced in the path of the beam 4 for selecting at least one, preferably a longitudinal, mode of the laser. The dispersion element 10 comprises a grating (not shown).

The tuning element 8 can be rotated by an actuator (not shown) about a pivot axis (not shown) to tune the laser. The pivot axis is theoretically defined by the intersection of the surface plane of the cavity end element 6, the surface plane of the dispersion element 10 and the surface plane of the tuning element 8.

It is clear that the positioning of the elements 6, 8, 10 according to Fig. 1 is only schematic and not the ideal case of the positioning of the elements 6, 8, 10. The elements 6, 8, 10 however can be positioned in another way, i.e. in other angles or positions as shown in Fig. 1.

In the path 4 of the laser beam there is introduced a liquid crystal LC 32. The LC 32 serves to change the optical length of the path 4 to at least partly compensate a shift between the real position of its rotation axis and the theoretically defined position (be aware that Fig. 1 is only a schematic illustration not to scale, therefore the axis is not shown). For further details about the predetermined path, reference is made to the parallel application mentioned above. In Fig. 1 are shown two collimators 34 and 36 to provide collimated laser light within the laser cavity (collimator 34) and to collimate the laser light 38 leaving the cavity end element 6 (collimator 36). The LC 32 is explained in further detail with respect to Fig. 2.

An example of a refractive index changing LC is shown in Fig 2. The LC 32 is a so-called nematic LC retarder that provides phase shifts up to several pi. A phase shift of one pi corresponds to 1 mode spacing in cavity 2 with liquid crystal molecules 40. The liquid crystal molecules 40 are confined by two electrodes, here indium tin oxide (ITO) layers 46. The ITO layers 46 are contacted by wires 44 to receive a potential V. Part a) of Fig. 2 shows a situation with V = 0. In this case, the liquid crystal molecules 40 are aligned parallel to each other. This alignment is induced by layers 42 located on layers 46. Layers 42 and 46 are supported by glass substrate layers 48. All layers 42, 46 and 48 are transparent for the laser light of light beam 4. However, liquid crystal molecules 40 in the LC 32 provide phase retardation to the laser light of light beam 4. This phase retardation is maximum with V = 0 as shown in part a) of Fig. 2.

When V is at its maximum the phase retardation is at its minimum as shown in part b) of Fig. 2. In this case, the liquid crystal molecules 40 are only partly aligned to each other.

The LC 32 does not change the state of polarization of light beam 4 as indicated by arrows 50 in Fig. 1.

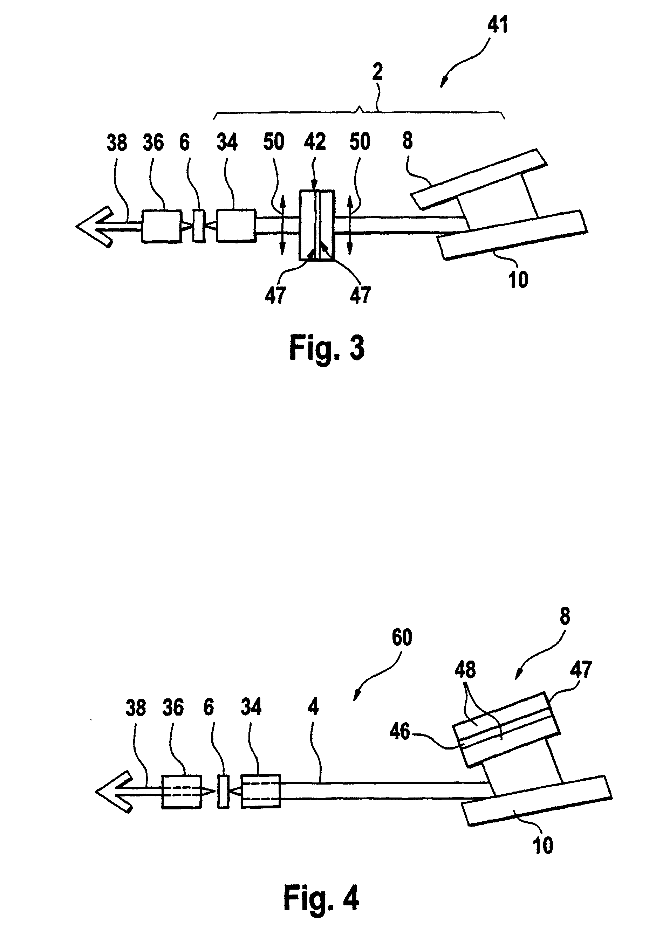

Fig. 3 shows a second embodiment 41 of the present invention. The general setup of embodiment 41 is similar to embodiment 1 of Fig. 1. However, in the path 4 of the laser beam there is introduced an etalon 42. The etalon 42 is built up by a LC 32 according to Fig. 2. The etalon 42 is slightly tilted with respect to the incoming beam 6 to avoid any unwanted multi mirror effects due to non perfect anti reflection coatings of the LC 32. However, the LC 32 is modified by two highly reflective coatings 47 placed on the inner surfaces of the ITO layers 46. Thereby, an etalon 42 is created which can be manipulated by the same electrical signal applied to etalon 42 of Fig. 2. However, by changing the voltage applied to etalon 42 the transmission wavelength of etalon 42 can be manipulated, preferably synchronized with the tuning mechanism of the tuning element 8 to reduce light of unwanted wavelength, for example SSE or longitudinal side modes.

Fig. 4 shows a fourth embodiment 60 of the present invention. In this embodiment, the LC 32 serves also as a tuning element 8. To serve as the tuning element 8 only one ITO layer is coated by a highly reflective coating 47.

## Claims

1. A method of tuning a laser, comprising the steps of:
providing a laser beam (4) to an external cavity (2), the laser beam (4) traveling through a material (32, 42) along a path (4) between a cavity end element (6) and a tuning element (8), the path (4) having an optical path length, and the material (32, 42) comprising a liquid crystal (32, 42) being sensitive in a characteristic property,
selecting at least one mode of the laser by introducing a dispersion element (10) in the path (4) of the laser, and
changing the optical path length of the path (4) by changing the characteristic property of the liquid crystal (32, 42) in a way which influences the optical path length of the path (4) to stabilize a mode of the laser.

2. The method of claim 1, wherein the characteristic property is at least one of thickness, optical path length, or refractive index.

3. The method of the claims 1 or 2, wherein the characteristic property is sensitive to at least one of voltage, magnetism, pressure, humidity, or temperature.

4. The method of claim 1 or any one of the above claims, further comprising the step of:
modulating the change of the optical path length of the path (4).

5. The method of claim 4, wherein the change of the optical path length of the path (4) is modulated using a modulation on a sinusoidal bases.

6. The method of claim 1 or any one of the above claims, further comprising the step of:
varying the optical path length in a function of the spatial, preferably lateral, position in the laser beam.

7. The method of claim 1 or any one of the above claims, further comprising the step of:
varying the characteristic property of the material spatially depending on the position in the laser beam.

8. The method of claim 7, wherein the characteristic property of the material is varied laterally.

9. The method of claim 1 or any one of the above claims, further comprising the steps of:
measuring the real wavelength,
comparing the real wavelength with the desired wavelength, and
generating a control signal depending on the deviation for controlling the amount of change necessary to at least partly compensate any deviation of a real wavelength from a desired wavelength.

10. The method of claim 1 or any one of the above claims, further comprising the steps of:
performing the change of the optical path length rapidly, preferably by deriving a control signal for the change from random noise to reduce the coherence of the laser.

11. The method of claim 1 or any one of the above claims, further comprising the step of:
synchronizing tuning of the laser with a transmission wavelength of the etalon (42) for reducing light at unwanted wavelengths.

12. A software program or product stored on a data carrier for executing the method of claim 1 or any one of the above claims, when run on a data processing system such as a computer.

13. An apparatus for tuning a laser, comprising:
an external cavity (2) for receiving a laser beam (4), the laser beam (4) traveling through material along a path (4) between a cavity end element (6) and a tuning element (8), the path (4) having an optical path length,
a dispersion element (10) introduced in the path (4) of the laser for selecting at least one mode of the laser, and
a changing element for changing the optical path length of the path (4), the changing element comprising a liquid crystal (32, 42) in at least a part of the path (4), the liquid crystal (32, 42) being sensitive in a characteristic property, the changing element being adapted for changing the characteristic property of the liquid crystal (32, 42) in a way which influences the optical path length of the path (4) to stabilize a mode of the laser.

14. The device of claim 13, wherein the characteristic property is at least one of thickness or refractive index of the material (32, 42).

15. The device of the claims 13 or 14, wherein the characteristic property of the liquid crystal (32, 42) is sensitive to at least on of voltage, magnetism, pressure, humidity, or temperature.

16. The device of any one of claims 13-15,
wherein the liquid crystal (32, 42) provides a spatial variation in its characteristic property.

17. The device of any one of the claims 3 - 16, wherein the liquid crystal (32, 42) provides a lateral variation in its characteristic property.

18. The device of any one of claim 13-17, wherein the liquid crystal (32, 42) is at least a part of an etalon (42).

19. A laser source, comprising:
an active medium adapted for providing a laser beam (4),
an external cavity (2) adapted for providing resonance to the laser beam (4), the beam 4 traveling in the cavity (2) along a path between a cavity end element (6) and a tuning element (8), the cavity end element (6) and the tuning element (8) both providing the cavity mirrors,
a dispersion element (10) introduced in the path of the beam (4) for selecting at least one mode of the laser, and
a liquid crystal (32) introduced in the path of the beam (4),
wherein the tuning element (8) can be rotated about a pivot axis for tuning the laser, and the pivot axis is theoretically defined by the intersection of the surface plane of the cavity end element (6), the surface plane of the dispersion element (10) and the surface plane of the tuning element (8), and
the liquid crystal (32) is adapted to change the optical length of the path (4) to at least partly compensate a shift between the real and the theoretically defined position of the pivot axis.

## Patentansprüche

1. Ein Verfahren zur Abstimmung eines Lasers mit folgenden Schritten:
Senden eines Laserstrahls (4) an eine externe Kavität (2), wobei der Laserstrahl (4) durch ein Material (32, 42) entlang eines Weges (4) läuft zwischen einem Kavitäts-Endelement (6) und einem Abstimmungs-Element (8), der Weg (4) eine optische Weglänge hat und das Material (32, 42) ein Flüssigkristall (32,42) aufweist mit Sensitivität in einer charakteristischen Eigenschaft,
Selektieren zumindest eines Modus des Lasers durch Einführen eines Dispersionselements (10) in dem Weg (4) des Lasers, und
Ändern der optischen Weglänge des Weges (4) durch Ändern der charakteristischen Eigenschaft des Flüssigkristalls (32,42) in einer Weise, welche die optische Weglänge des Weges (4) beeinflusst zur Stabilisierung eines Modus des Lasers.

2. Das Verfahren nach Anspruch 1, wobei die charakteristische Eigenschaft mindestens Dicke, optische Weglänge oder Brechungsindex ist.

3. Das Verfahren nach Anspruch 1 oder 2, wobei die charakteristische Eigenschaft sensitiv ist gegenüber mindestens Spannung, Magnetismus, Druck, Feuchtigkeit oder Temperatur.

4. Das Verfahren nach Anspruch 1 oder einem der o.g. Ansprüche, mit zusätzlich folgendem Schritt:
Modulieren der Änderung der optischen Weglänge des Weges (4).

5. Das Verfahren nach Anspruch 4, wobei die Änderung der optischen Weglänge des Weges (4) moduliert wird mittels einer Modulation.

6. Das Verfahren nach Anspruch 1 oder einem der o.g. Ansprüche mit zusätzlich folgendem Schritt:
Variieren der optischen Weglänge in einer Funktion der räumlichen, vorzugsweise seitlichen, Position in dem Laserstrahl.

7. Das Verfahren nach Anspruch 1 oder einem der o.g. Ansprüche mit zusätzlich folgendem Schritt:
Variieren der charakteristischen Eigenschaft des Materials räumlich abhängig von der Position in dem Laserstrahl.

8. Das Verfahren nach Anspruch 7, wobei die charakteristische Eigenschaft des Materials seitlich variiert wird.

9. Das Verfahren nach Anspruch 1 oder einem der o.g. Ansprüche mit zusätzlich folgenden Schritten:
Messen der realen Wellenlänge,
Vergleichen der realen Wellenlänge mit der gewünschten Wellenlänge, und
Generieren eines Kontrollsignals abhängig von der Abweichung zum Kontrollieren des Änderungsbetrags, der erforderlich ist, um jegliche Abweichung der realen Wellenlänge von der gewünschten Wellenlänge zumindest teilweise zu kompensieren.

10. Das Verfahren nach Anspruch 1 oder einem der folgenden Ansprüche mit zusätzlich folgenden Schritten:
Schnelles Durchführen der Änderung der optischen Weglänge, vorzugsweise durch Ableiten eines Kontrollsignals für die Änderung von Zufalls-Rauschen zum Reduzieren der Kohärenz des Lasers.

11. Das Verfahren nach Anspruch 1 oder einem der o.g. Ansprüche mit zusätzlich folgendem Schritt:
synchronisiertes Abstimmen des Lasers mit einer Übertragungswellenlänge des Etalons (42) zum Reduzieren von Licht bei ungewollten Wellenlängen.

12. Ein Softwareprogramm oder Produkt, gespeichert auf einem Datenträger, zum Durchführen des Verfahrens nach Anspruch 1 oder einem der o.g. Ansprüche, wenn es auf einem Datenverarbeitungssystem wie einem Computer durchgeführt wird.

13. Eine Vorrichtung zur Abstimmung eines Lasers mit:
einer externen Kavität (2) zum Empfangen eines Laserstrahls (4), wobei der Laserstrahl (4) durch Material läuft entlang eines Wegs (4) zwischen einem Kavitäts-Endelement (6) und einem Abstimmungs-Element (8) und der Pfad eine optische Weglänge hat;
ein Dispersionselement (10), das in den Weg (4) des Lasers eingeführt wird, zum Selektieren zumindest eines Modus des Lasers, und
ein Änderungselement zum Ändern einer optischen Weglänge des Wegs (4), wobei das Änderungselement ein Flüssigkristall (32,42) aufweist in zumindest einem Teil des Wegs (4), das Flüssigkristall (32, 42) sensitiv ist in einer charakteristischen Eigenschaft, das Änderungselement angepasst ist zum Ändern der charakteristischen Eigenschaft des Flüssigkristalls (32,42) in einer Weise, welche die optische Weglänge des Wegs (4) beeinflusst, zur Stabilisierung eines Modus des Lasers.

14. Die Vorrichtung nach Anspruch 13, wobei die charakteristische Eigenschaft mindestens Dicke oder Brechungsindex des Materials (32,42) ist.

15. Die Vorrichtung nach Anspruch 13 oder 14, wobei die charakteristische Eigenschaft des Flüssigkristalls (32,42) mindestens gegenüber Spannung, Magnetismus, Druck, Feuchtigkeit oder Temperatur sensitiv ist.

16. Die Vorrichtung nach den Ansprüchen 13-15, wobei das Flüssigkristall (32,42) eine räumliche Variation in ihrer charakteristischen Eigenschaft liefert.

17. Die Vorrichtung nach einer der Ansprüche 13 - 16, wobei das Flüssigkristall (32,42) eine seitliche Variation in ihrer charakteristischen Eigenschaft liefert.

18. Die Vorrichtung nach einem der Ansprüche 13-17, wobei das Flüssigkristall (32,42) zumindest ein Teil eines Etalons (42) ist.

19. Eine Laserquelle, mit:
einem aktiven Medium angepasst zum Liefern eines Laserstrahls (4),
einer externen Kavität (2) angepasst zum Liefern von Resonanz an den Laserstrahl (4), wobei der Strahl (4) die Kavität (2) durchläuft entlang eines Wegs zwischen einem Kavitäts-Endelement (6) und einem Abstimmungselement (8) und das Kavitäts-Endelement (6) und das Abstimmungselement (8) beide die Kavitätsspiegel liefern,
einem Dispersionselement (10), das in den Weg des Strahls (4) eingeführt wird, zum Selektieren zumindest eines Modus des Lasers, und
ein Flüssigkristall (32), das in den Weg des Lasers (4) eingeführt wird,
wobei das Abstimmungselement (8) um eine Drehachse rotiert werden kann zum Abstimmen des Lasers und die Drehachse theoretisch definiert wird durch die Kreuzung der Oberflächenebene des Kavitäts-Endelements (6), der Oberflächenebene des Dispersionselements (10) und der Oberflächenebene des Abstimmungselements (8), und
das Flüssigkristall (32) angepasst ist zum Ändern der optischen Weglänge (4), um eine Verschiebung der realen und der theoretisch definierten Position der Drehachse zumindest teilweise zu kompensieren.

## Revendications

1. Un procédé d'accord d'un laser, qui comprend les étapes consistant à:
envoyer un faisceau laser (4) vers une cavité externe (2), le faisceau laser (4) parcourant une matière (32, 42) le long d'un trajet (4) entre un élément d'extrémité (6) de cavité et un élément d'accord (8), le trajet (4) présentant une longueur de trajet optique, et la matière (32, 42) comprenant un cristal liquide (32, 42) qui est sensible à une propriété caractéristique,
sélectionner au moins un mode du laser en introduisant un élément de dispersion (10) dans le trajet (4) du laser, et
modifier la longueur de trajet optique du trajet (4) en modifiant la propriété caractéristique du cristal liquide (32, 42) d'une manière qui influence la longueur de trajet optique du trajet (4) afin de stabiliser un mode du laser.

2. Le procédé selon la revendication 1, dans lequel la propriété caractéristique est au moins soit l'épaisseur, soit la longueur du trajet optique, soit l'indice de réfraction.

3. Le procédé selon la revendication 1 ou 2, dans lequel la propriété caractéristique est sensible au moins soit à la tension, soit au magnétisme, soit à la pression, soit à l'humidité, soit à la température.

4. Le procédé selon l'une quelconque des revendications précédentes, qui comprend en outre l'étape consistant à:
moduler la modification de trajet optique du trajet (4).

5. Le procédé selon la revendication 4 dans lequel la modification de la longueur de trajet optique du trajet (4) est modulée en utilisant une modulation à base sinusoïdale.

6. Le procédé selon l'une quelconque des revendications précédentes qui comprend en outre l'étape consistant à:
modifier la longueur du trajet optique en fonction de la position spatiale, de préférence latérale, dans le faisceau laser.

7. Le procédé selon l'une quelconque des revendications précédentes, qui comprend en outre l'étape consistant à:
modifier spatialement les propriétés caractéristiques de la matière en fonction de la position dans le faisceau laser.

8. Le procédé selon la revendication 7 dans lequel la propriété caractéristique de la matière est modifiée latéralement.

9. Le procédé selon l'une quelconque des revendications précédentes qui comprend en outre les étapes consistant à:
mesurer la longueur d'onde réelle;
comparer la longueur d'onde réelle à la longueur d'onde souhaitée; et
engendrer un signal de réglage qui dépend de l'écart afin de régler l'ampleur de la modification nécessaire pour compenser au moins partiellement tout écart de la longueur d'onde réelle par rapport à une longueur d'onde souhaitée.

10. Le procédé selon l'une quelconque des revendications précédentes qui comprend en outre les étapes consistant à:
exécuter rapidement la modification de la longueur de trajet optique, de préférence en dérivant d'un bruit aléatoire un signal de réglage pour la modification afin de réduire la cohérence du laser.

11. Le procédé selon l'une quelconque des revendications précédentes, qui comprend en outre l'étape consistant à:
synchroniser un accord du laser avec une longueur d'onde de transmission de l'étalon (42) afin de réduire la lumière à des longueurs d'ondes indésirables.

12. Un programme ou produit de logiciel, enregistré sur un porteur de données, pour exécuter le procédé selon l'une quelconque des revendications précédentes, lorsqu'il est mis en ouvre sur un système de traitement de données comme un ordinateur.

13. Un appareil d'accord d'un laser, qui comprend:
une cavité externe (2) pour recevoir un faisceau laser (4), le faisceau laser (4) parcourant une matière le long d'un trajet (4) entre un élément d'extrémité (6) de cavité et un élément d'accord (8), le trajet (4) présentant une longueur de trajet optique,
un élément de dispersion (10) introduit dans le trajet (4) du laser afin de sélectionner au moins un mode du laser, et
un élément modificateur pour modifier la longueur de trajet optique du trajet (4), l'élément modificateur comprenant un cristal liquide (32, 42) dans au moins une partie du trajet (4), le cristal liquide (32, 42) étant sensible à une propriété caractéristique, l'élément modificateur étant apte à modifier la propriété caractéristique du cristal liquide (32, 42) d'une manière qui influence la longueur de trajet optique du trajet (4) afin de stabiliser un mode du laser.

14. Le dispositif selon la revendication 13, dans lequel la propriété caractéristique est au moins soit l'épaisseur, soit l'indice de réfraction de la matière (32, 42).

15. Le dispositif selon la revendication 13 ou 14, dans lequel la propriété caractéristique du cristal liquide (32, 42) est sensible au moins soit à la tension, soit au magnétisme, soit à la pression, soit à l'humidité, soit à la température.

16. Le dispositif selon l'une quelconque des revendications 13 à 15, dans lequel le cristal liquide (32, 42) réalise une variation spatiale de sa propriété caractéristique.

17. Le dispositif selon l'une quelconque des revendications 13 à 16, dans lequel le cristal liquide (32, 42) réalise une variation latérale de sa propriété caractéristique.

18. Le dispositif selon l'une quelconque des revendications 13 à 17 dans lequel le cristal liquide (32, 42) est au moins une partie d'un étalon (42).

19. Une source laser qui comprend:
un support actif apte à envoyer un faisceau laser (4),
une cavité externe (2) apte à établir une résonance pour le faisceau laser (4), le faisceau laser (4) parcourant la cavité (2) le long d'un trajet entre un élément d'extrémité (6) de cavité et un élément d'accord (8), l'élément d'extrémité (6) de cavité et l'élément d'accord (8) constituant tous deux des miroirs de cavité,
un élément de dispersion (10) introduit dans le trajet du faisceau (4) pour sélectionner au moins un mode du laser, et
un cristal liquide (32) introduit dans le trajet du faisceau (4),
dans lequel l'élément d'accord (8) peut tourner autour d'un axe de pivot pour accorder le laser, et l'axe de pivot est défini théoriquement par l'intersection entre le plan de surface de l'élément d'extrémité (6) de cavité, le plan de surface de l'élément de dispersion (10) et le plan de surface de l'élément d'accord (8), et
le cristal liquide (32) est apte à modifier la longueur optique du trajet (4) pour compenser au moins partiellement un décalage entre la position réelle de l'axe du pivot et sa position définie théoriquement.
